# EUROPEAN PATENT APPLICATION

(11) **EP 0 540 448 A1**
(43) Date of publication of application: **05.05.1993**
(21) Application number: 92480150.9
(22) Date of filing: 09.10.1992
(51) Int. Cl.: G03F 7/11, G03F 7/20

(54) **Base developable discharge toplayer for E-beam resists**

(30) Priority: 31.10.1991 US 786200
(71) Applicant: International Business Machines Corporation, Armonk, N.Y. 10504 (US)
(72) Inventor: Huang, Wu-Song, Poughkeepsie, N.Y. 12603 (US); Kwong, Ranee W., Wapinger Falls, N.Y. 12590 (US); Ross, Gerald J., Poughkeepsie, N.Y. 12603 (US); Sachdev, Harbans S., Hopewell Junction, N.Y. 12533 (US)
(74) Representative: Klein, Daniel Jacques Henri

(57) **Abstract**

Aqueous base soluble conducting polymers are disclosed, as is their use to dissipate an electrical charge and thereby to improve the precision of processes involving charged particle beams. Electrically conductive functionalized polymers include polyanilines, polyparaphenylvinylenes, polythiophenes, polypyrroles, poly-p-phenylene oxides, polyfurans, polyphenylenes, polyazines, polyselenophenes, polyphenylene sulfides and polyacetylenes. Also disclosed are processes for the synthesis of poly(hydroxyanilines) and polythiophenes and compositions and methods for preparing aqueous base soluble conductive films.

## Description

The present invention relates to aqueous base soluble conducting polymers and their use to dissipate an electrical charge and thereby to improve the precision of processes involving charged particle beams. In particular, it relates to electrically conductive functionalized polymers including polyparaphenylvinylenes, polyanilines, polyazines, polythiophenes, poly-p-phenylene sulfides, poly-p- phenylene oxides, polyfurans, polypyrroles, polyselenophenes, and polyacetylenes. The polymers contain functional groups which render them soluble in aqueous base, and conjugated pi systems which allow electrical conductivity by electronic rather than ionic mechanisms.

In the lithographic area, electron beam (E-beam) direct-write technology is one of the most reliable methods for obtaining resist images having high accuracy in level to level pattern overlay of submicron features. The technology has been successfully used in microcircuit fabrication for submicron devices. However, the present resists are insulating dielectric materials which trap charges and generate an electrical field on the resist surface. This charge deflects the incoming electron beam and causes landing errors or even defocusing, especially when thick insulating substrates are used under resists. The problem of charge accumulation in the resist is usually addressed by depositing an electrically conductive metal layer over or under the resist to dissipate the trapped charges. This approach has many disadvantages: expensive metal deposition tools are required; the process is complicated; resists are often pre-exposed; resist failures occur in the metal-removing process; and the metal discharge layers usually give lower yield and larger variation in line width control of resist images. Polymer discharge layers are potentially attractive alternatives for process simplification, cost reduction and performance enhancement.

Japanese published application 62/113,134 (Chem. Abst. 108: 65998z) discloses a complex salt solution consisting of a macromolecular polycation and tetracyanoquinodimethane (TCNQ) which are dissolved in cyclohexanone and applied over an electron-beam resist. Submicron patterns, for manufacturing very-large-scale integrated circuits, are formed using the resist. Thus a silicon substrate having a methacrylate-type resist was coated with cyclohexanone solution of poly(vinylbenzyltriethylammonium)-TCNQ complex salt solution, patterned by a scanning electron beam, developed, and rinsed to form a resist pattern. This type of polymer discharge layer can only be removed with organic solvents; it is suitable for solvent developable but not for aqueous base developable resist systems.

Watanabe and Todokoro [IEEE Trans. of Electron Devices, 36, 474, (1989)] describe an E-beam direct wafer writing process using a water-soluble conductive layer which is poly(p-styrene sulfonate). The polymer discharge layer is applied to the E-beam resist surface prior to conventional exposure, subsequently removed, and the E-beam resist developed. The authors state that "a deviation [in E-beam accuracy] of 0.2 microns still remains" after using the poly(p-styrene sulfonate) water soluble conductive layer. Poly (p- styrene sulfonate) conducts charge by the movement of ions rather than by the transfer of electrons in a delocalized pi system, and its performance as a conductive layer is inherently limited by virtue of this mechanism.

Angelopoulos et al. [J. Vac. Sci. Technol. B 7, 1519-1523 (1989)] disclose a discharge layer for electron-beam lithography comprising unsubstituted polyaniline coated under the imaging resist. The polyaniline is cast in the nonconducting form and is activated by soaking the individual wafers in acid for 6 hours or by exposure to UV. It can only be used under the resist.

Patil et al. [J. Am. Chem. Soc. 109, 1858 (1987)] describe the synthesis of acid and sodium salt forms of poly 3-(4-butanesulfonate) thiophene and poly 3-(2-ethanesulfonate) thiophene using electropolymerization. The polymer is stated to have a conductivity of about 10 S/cm after treatment with bromine. The authors do not discuss the utility of the polymer.

Yue and Epstein [J. Am. Chem. Soc. 112, 2800 (1990)] describe the synthesis of a sulfonic acid ring- substituted polyaniline. The polymer has a conductivity of 0.1 S/cm when the solid is equilibrated with water solution at or below pH 7. When the water solution is made basic (> pH 7) the polymer is dissolved, but at the same time, is converted to the nonconducting form. The utility of the polymer is not discussed.

Bergeron et al. [J. Chem. Soc. Chem. Comm., 1990, 180] describe the synthesis of poly(aniline propane sulfonic acid), the sodium salt of which displays an electrical conductivity of 10⁻⁵ S/cm. The authors state that the sodium salt could be cast from N- methylpyrrolidinone solution as a film on various substrates.

US-A- 4.025.704 and its divisionals 4.025.691 and 3,963,498 disclose polyaniline semiconductors that are soluble in organic solvents and have resistivities between 10⁻³ and 10⁹ ohm/cm. The semiconductors may be cast, as films and are said to be useful as antistatic films and may be used in the production of resistors, capacitors, rectifiers and transistors. Except for the end groups, the polyanilines are unsubstituted.

US-A- 4.889.659 discloses "nitrogenized electronic conductive polymers" of formula [NH-(CH = CH)ₙ]ₓ for use as battery electrodes. Numerous other utilities are suggested.

US-A- 4.526.706 discloses a method of using polyanilines to prepare conductive films in aqueous systems by preparing dispersions in the presence of latex.

US-A- 4.629.540 discloses a process for preparing polyanilines by oxidation of the appropriate monomer in a superacid in the presence of fluoride anion.

There thus remains a need for an aqueous base soluble composition that can be easily applied to a surface of a dielectric material to dissipate an electrical charge generated on the dielectric material by the impact of charged particles from a charged particle beam.

It is an object of the present invention to provide an aqueous base soluble composition that can be easily applied to a surface of a dielectric material to dissipate an electrical charge generated on the dielectric material by the impact of charged particles from a charged particle beam.

It is a further object to provide a composition for charge dissipation that can be removed without altering an aqueous base insoluble surface to which it is applied.

It is a further object to provide a composition such that, in the case where the dielectric material is a base soluble resist, the removal of the charge- dissipating composition and the development of the resist may be accomplished in one step.

It is another object of the invention to provide base soluble, electrically conductive polymer that can be used in compositions for charge dissipation.

It is another object to provide a process for improving the precision of electron beam lithography without the need for providing a metallic charge- dissipating layer.

In a composition aspect, the invention relates to compositions for dissipating the accumulated charge from a charged particle beam which comprise from 15 to 100% of an electrically conductive, aqueous base soluble polymer or oligomer chosen from the group consisting of substituted and unsubstituted polyparaphenylvinylenes, polyanilines, polyazines, polythiophenes, poly-p-phenylene sulfides, poly-p- phenylene oxides, polyfurans, polypyrroles, polyselenophenes, and polyacetylenes. Polyanilines and polythiophenes are preferred. Poly(o-hydroxyaniline) and poly[3-(2-ethanesulfonate) thiophene] are most preferred.

In a compound aspect, the invention relates to electrically conductive polymers or oligomers having the formula 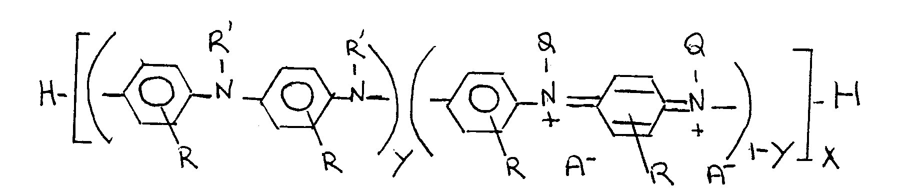
wherein:
R is OH, OCH₃ or COOH;
R¹ is hydrogen or lower-alkyl;
Q is hydrogen or lower-alkyl;
y is a number between zero and one
x is a number from 4 to 1,100; and
A⁻ is any anionic species.

Compounds wherein R is OH and Q is hydrogen are preferred. Particularly preferred are those wherein R¹ is hydrogen, y is from 0.4 to 0.6, x is from 50 to 750 and A⁻ is Br⁻.

In a process aspect, the invention relates to a process for preparing a polymer of formula 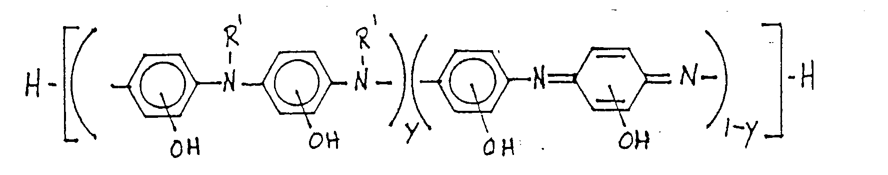
which comprises reacting a polymer of formula 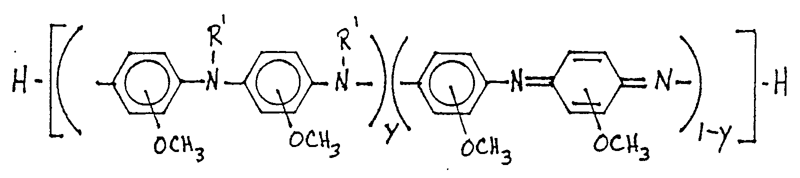
with 48% hydrobromic acid.

In a further process aspect, the invention relates to a process for preparing a polythiophene of formula 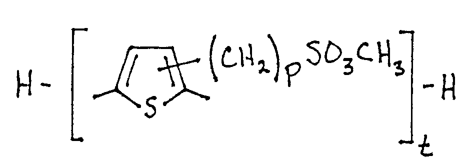
wherein t is an integer from 4 to 6,100 and p is an integer from 1 to 4, which comprises reacting a methyl -(3-thienyl) alkylsulfonate with from about 2 to about 3 equivalents of ferric chloride in an inert solvent, preferably nitromethane.

In yet a further process aspect, the invention relates to a process for improving the precision of a charged particle beam impinging on a dielectric surface which comprises disposing over a least a part of said surface, a non-metallic, electrically conductive material chosen from the group consisting of aqueous base soluble, substituted and unsubstituted polyparaphenylvinylenes, polyanilines, polyazines, polythiophenes, poly-p-phenylene sulfides, poly-p- phenylene oxides, polyfurans, polypyrroles, polyselenophenes, and polyacetylenes.

One aspect of charged particle beam precision that is of particular interest is the process for electron beam lithography which comprises:
a) coating a substrate with at least one layer of a resist, preferably an aqueous base developable resist;
b) coating at least a portion of said resist layer with a nonmetallic, electrically conductive material chosen from the group consisting of aqueous base soluble substituted and unsubstituted polyparaphenylvinylenes, polyanilines, polyazines, polythiophenes, poly-p-phenylene sulfides, poly-p-phenylene oxides, polyfurans, polypyrroles, polyselenophenes, and polyacetylenes, preferably poly(o-hydroxyaniline);
c) exposing said substrate with said resist and said nonmetallic, electrically conductive material thereon to an electron beam, said nonmetallic material substantially preventing charge accumulation; and
d) removing said nonmetallic material and developing said resist.

For the purposes of the invention lower-alkyl means straight or branched hydrocarbon residues of six or fewer carbons. Soluble means having a solubility not less than 0.01% by weight. Conductive means that a layer 0.2 microns thick exhibits a conductivity greater than 10⁻³ S/cm when measured by the standard four-point probe method.

Most of the advanced resist systems presently in use are aqueous base developable. When an aqueous base soluble discharge layer according to the present invention is applied on top of the resist, the discharge layer can be removed at the same time as the resist image is developed. This simplifies the process and is therefore the preferred arrangement of the conductive layer. It is preferred that the polymer discharge layer be soluble in water so that the polymer solution can be spin-coated on the resist. The thickness of the discharge layer is optimally in the range of 0.1-0.2 microns.

In accordance with the present invention, aqueous base developable discharge layers for use in charged particle beam (ion beam, electron beam) exposure of photoresists are provided which comprise an electrically conducting polymer containing an aqueous- base-solubilizing substitutent. The conducting polymers used here contain conjugated pi systems. The polymer chain length is not limited; it can be a high molecular weight, long chain polymer or a short chain oligomer containing four to five repeat units. In the conducting state, these polymers carry charges on the polymer chain, and dopants act as counter ions whose presence results in an expansion of the pi conjugated system. It is not necessary that the pi conjugated system extend over the full molecule. It is only necessary that the pi conjugated system of an individual molecule can overlap a part of a pi conjugated region in an adjacent molecule. Therefore, it will be apparent to those skilled in the art that copolymers of conducting polymers and insulating polymers or blends of conducting polymers and insulating polymers will also function according to this invention. The dopants described here can be free ions or ions linked to the polymer as substitutents. They may be mono-ions, di-ions, tri-ions, even polyions.

One type of polymer useful in the practice of the present invention is a substituted polyaniline having the formula 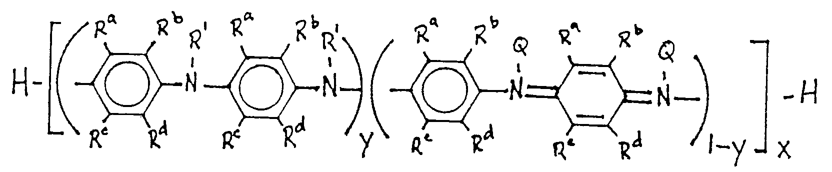
wherein at least one of the R and Q has an aqueous base solubilizing component. R, R¹ and Q independently represent hydrogen, organic or inorganic radicals; x is from 4 to 1,100, preferably 50 to 750 and y has a value from 0 to 1. Examples of organic radicals are alkyl or aryl radicals. Examples of inorganic radicals are Si and Ge. This list is exemplary only and not limiting. The most preferred embodiment is the emeraldine base form of the polyaniline wherein y has a value of 0.5. The foregoing formula and similar ones which follow are written for simplicity with localized charges and localized double bonds. Actually, the charges distribute through the nitrogen atoms and aromatic rings making the imine and amine nitrogen atoms indistinguishable. In the conductive state, Q is any residue that renders the adjacent nitrogen cationic, for example, Q may be lower alkyl, a metal such as Cu^{H} or an alkyl group carrying an aqueous base solubilizing component. Preferably Q is H. Examples of aqueous base solubilizing components are -OH, or -COO⁻M⁺, or -SO₃⁻M⁺, wherein M⁺ is H⁺, Na⁺, K⁺, NH₄⁺, or (Me)₄N⁺. When -COO⁻ or -SO₃⁻ are present they may serve as counter anions, and the polymer becomes self doped. These substituents may be sufficient to dope the polymer to adequate conductivity or free counter anions may be needed. When non-anionic aqueous base solubilizing substituents are present, a free anion is needed as a dopant. Examples of free anions are: CF₃SO₃⁻, C₆H₅SO₃⁻, SO₄⁼, NO₃⁻, C10₄⁻, BF₄⁻, C1⁻, Br⁻, I⁻, AsF₆⁻, SbF₆⁻, FeCl₄⁻ , SnCl6⁻ polyacrylate, and poly (benzene sulfonate).

Most aqueous base soluble polymers are also soluble in neutral or acidic water. It is preferred that the conducting polymer is water soluble and spin coatable. If the polymer is not soluble or has limited solubility, the conducting polymer can be blended with water soluble insulating polymers. It is preferred that the proportion of conducting polymer be above 15% of the total volume to achieve significant conductivity. Above this volume, the chance of conducting polymer chains overlapping each other is high enough to ensure adequate conductivity of the layer. The use of insulating polymer and conducting polymer is not limited to conducting polymers with low water solubility; advantages may be obtained as well with highly soluble conducting polymers. Examples of water soluble insulating polymers are polystyrene sulfonic acid, polyacrylic acid, polyvinylalcohol, polyethylene oxide, polyvinyl pyrrolidone, polymethacrylic acid, and carboxymethylcellulose.

Polythiophenes may also be utilized in the present invention. Polythiophenes have general formula: 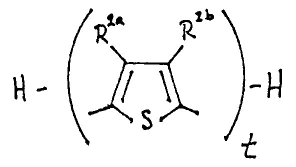
wherein t is an integer from 4 to 6,100; R^{2a} and R^{2b} are H or an organic or inorganic radical; and at least one R² contains an aqueous base solubilizing component. It is known that thiophenes have higher redox potentials than polyanilines. The aqueous base soluble conducting polythiophenes are often not conductive enough to dissipate all the trapped charge to prevent image distortion in the charged beam exposure. In this event water soluble oxidants are used to boost the conductivity. This manipulation can be practiced to advantage on all conducting polymers. Examples of oxidants are ammonium persulfate, hydrogen peroxide, ferric trichloride, and perchloric acid.

Polyparaphenylvinylenes useful in the practice of the present invention have general formula: 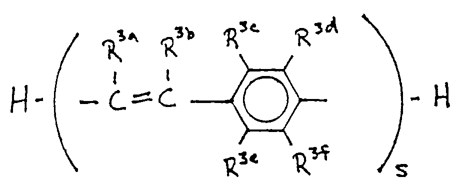
wherein s in an integer from 4 to 4,900; R³ is H or an organic or inorganic radical, each R³ can be the same or different, and at least one R³ has an aqueous base solubilizing component.

Polypyrroles useful in the practice of the present invention have general formula: 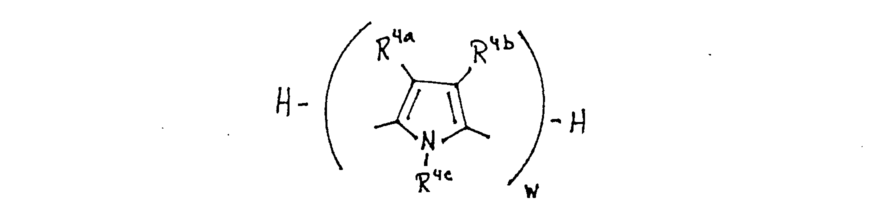
wherein w is an integer from 4 to 7,500; R⁴ is H or an organic or inorganic radical, each R⁴ can be the same or different, and at least one R⁴ has an aqueous base solubilizing component.

Polyfurans useful in the practice of the present invention have general formula: 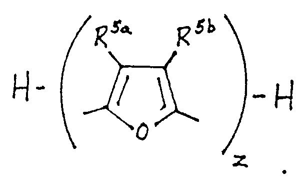
wherein z is an integer from 4 to 7,600; each R⁵ is H or an organic or inorganic radical, each R⁵ can be the same or different, and at least one R⁵ has an aqueous base solubilizing component.

Polyselenophenes useful in the practice of the present invention have general formula: 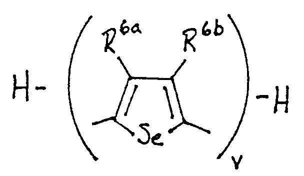
wherein v is an integer from 4 to 4,000; each R⁶ is H or an organic or inorganic radical, each R⁶ can be the same or different, and at least one R⁶ has an aqueous base solubilizing component.

Polyazines useful in the practice of the present invention have general formula: 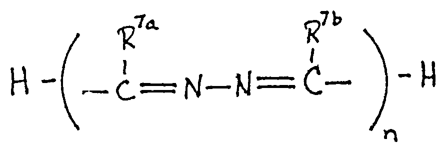
wherein n is an integer from 4 to 9,700; R⁷ is H or an organic or inorganic radical, each R⁷ can be the same or different, and at least one R⁷ has an aqueous base solubilizing component.

Examples of combinations of polythiophenes, polyfurans, polypyrroles and polyselenophenes useful in the practice of the present invention are represented by the following formula: 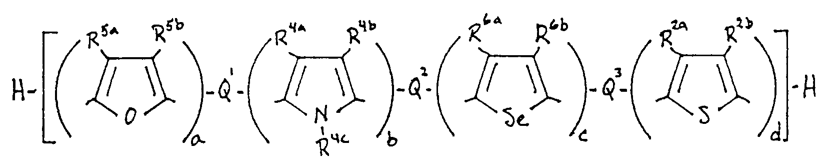
wherein R⁴, R⁵, and R⁶ are as defined above; at least two of a, b, c and d are greater than or equal to 1; m is an integer from 4 to 7,500 and Q¹, Q², and Q³ are a vinylene group or a direct bond between adjacent constitutents.

Poly-p-phenylene sulfides useful in the practice of the present invention have general formula: 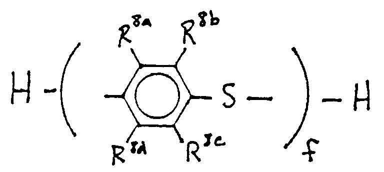
wherein f is an integer from 4 to 4,700; R⁸ is H or an organic or inorganic radical; each R⁸ can be the same or different, and at least one R⁸ has an aqueous base solubilizing component.

Poly-p-phenylene oxides useful in the practice of the present invention have general formula: 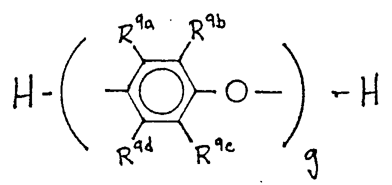
wherein g is an integer from 4 to 5,500; R⁹ is H or an organic or inorganic radical; each R⁹ can be the same or different, and at least one R⁹ has an aqueous base solubilizing component.

Polyacetylenes useful in the practice of the present invention have general formula: 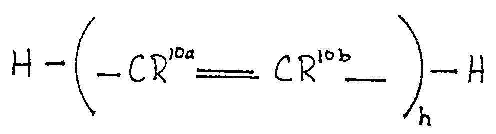
wherein h is an integer from 4 to 12,500; R¹⁰ is H or an organic or inorganic radical; each R¹⁰ can be the same or different, and at least one R¹⁰ has an aqueous base solubilizing component.

One aspect of the present invention is the provision of polymer discharge layers for aqueous base developable resist systems. The polymers of the invention are spin coated onto the resist from an aqueous solution. After the resist has been exposed with a charged particle beam, the discharge layer can be removed and the resist simultaneously developed by exposure to aqueous base.

Aqueous base soluble discharge layers may also be used advantageously with organic solvent developable resist systems. In this case the polymer discharge layer has to be removed with water or aqueous base before the resist image can be developed by the organic solvent. However, there is an obvious advantage in that the aqueous solution will not interfere with the resist during the process of spin coating the discharge layer onto the resist. Thus a second aspect of the invention is the provision of polymer discharge layers for organic solvent developable resist systems.

Yet a third aspect of the invention is the provision of soluble discharge layers for electron microscopy. In this case the object to be visualized is coated with the conductive polymer as above, and after visualization, the discharge layer is removed by dissolution of the polymer. The object is recovered for further use. The use of soluble discharge layers provides a significant improvement over visualization technology utilizing metallic conductors because the object being visualized is not rendered unfit for further use.

### Example 1

Methyl 2-(3-thienyl)ethanesulfonate was synthesized from 2-(3-thienyl)methanol as reported by A.O. Patil et al. [J. Am. Chem. Soc. 109, 1858 (1987)]. This "monomer" was polymerized by a chemical polymerization method that was developed to replace the lower-yielding electrochemical method reported in the literature. A solution of 2.3 equivalents of ferric trichloride in nitromethane was added to one equivalent of methyl 2-(3-thienyl)ethanesulfonate in nitromethane at 0°C with stirring. After completion of the addition the reaction was allowed to warm slowly to room temperature and reaction was continued overnight. The solution was then diluted with ether, and the polymer product, as a black precipitate, was filtered off. The sulfonyl ester polymer was converted to the sodium salt as reported in the above literature using sodium iodide in acetone. The yield of poly 3-(2- ethanesulfonate) thiophene sodium salt from methyl 2-(3-thienyl)ethanesulfonate monomer was greater than 90%. The acid form of the polymer can be obtained by passing an aqueous solution of the polymer sodium salt through a strong acid ion exchange resin such as Amberlite IR 120. The polymer ammonium salt can be obtained by neutralizing the polymer acid solution with ammonium hydroxide.

### Example 2

Polyanisidine was prepared by a method analogous to that of Huang et al. [J. Chem. Soc. Faraday Trans. 1, 82, 2385 (1986)]. Anisidine (o-methoxyaniline) was polymerized in aqueous acidic medium in the presence of ammonium persulfate. The polyanisidine salt was converted to the base form by treatment with ammonium hydroxide. The yield of the polymer was 15-25%. Polyhydroxyaniline was obtained by ether cleavage of polyanisidine. Experiments using boron tribromide, trimethyl silicon iodide, pyridine hydrochloride and pyridine hydrobromide only gave partially base soluble materials. (Presumably incomplete ether cleavage.) Completely base soluble poly(o-hydroxyaniline) was obtained by cleaving the ether group of polyanisidine with 48% hydrobromic acid. The polyanisidine base was slurried in 48% hydrobromic acid and refluxed with stirring overnight. The powder became very sticky and very difficult to filter. The acid and solid mixture was diluted with water and a large amount of acetone and the solid was filtered off and pumped dry. The yield was 40-60% of dried polymer which was soluble in KOH developer and tetramethyl ammonium hydroxide developer. It had very low solubility in pure water.

### Example 3

It is contemplated that, following the procedure of example 2, polycarboxyaniline may be synthesized from methyl anthranilate by polymerization followed by saponification of the methyl ester with alcoholic potassium hydroxide.

### Example 4 (Control)

To examine the charging effect on a resist during E-beam exposure, a "Hontas Discharge Test" was performed as described by Angelopoulos et al. [J. Vac. Sci. Technol. B 7, 1519-1523 (1989)]. The test was run at 25 Kev with a dose of 25 µC/cm². Briefly, the test is carried out as follows:

An electron beam moves from right to left, then from left to right in continuous fashion. The beam writes 400 small squares (2 micron x 2 micron) on each of two chips on one 5 mm wafer. The squares are located 250 microns apart in both directions. This gives a density of 6.4 x 10⁻³%. Since the density is low, no charging will occur on these squares. The electron beam is then moved to the top-right corner and starts to expose the whole chip area except for 10 micron squares around each small 2 micron square. This pattern has a density of 99.85%.

In this test, the inner square is acting as a reference. When there is no charging effect, the 2 micron square will always reside at the center of the 10 micron square. If there is a charging effect on the resist, the 2 micron square will appear displaced from the center. In general, the first square at the top-right corner shows very little effect from charging due to the small exposed area. On the other hand, the last square (400th) at the bottom-left corner will be strongly influenced by the charging due to the high density of the exposed area. The displacement of the 2 micron square from the center of the 10 micron square indicates the extent of charging on the resist. The charging phenomenon is considered to result from electrons trapped on the resist which start to build up a potential on the surface. This negative electrical field then repels the electron beam away from the set target point and consequently distorts the image pattern on the resist.

A multilayer resist system for E-beam discharge was tested as a control. A 5000 angstrom layer of SiO₂ was thermally grown on the surface of a silicon wafer. A 2.8 micron resist of AZ4210 as a planarization layer was spin coated on top of the SiO₂ and baked at 230°C for 30 min. A one micron diazonaphthoquinone-novolak positive resist was spin coated on top of the hard baked AZ4210 photoresist and was baked for 30 min at 85°C. No discharge layer was put on the image resist. The "Hontas Discharge Test" was then carried out on the resist. The resist was developed in 0.255 N KOH developer for 9.5 min. The image on the last 2 micron square significantly shifted away from the center of the 10 micron square. The image distortion is due to the strong charging on the resist surface. The displacement of the 2 micron square from the center is about 5 microns. This experiment served as a reference control for the discharge test.

### Example 5

Although poly(o-hydroxyaniline) has very limited solubility in distilled water, it can be dissolved in water by adding an equal weight of polyvinylalcohol to the water solution. Polyether surfactants such as Sherex ^{TM} (ethoxylated isostearyl alcohol) and Tetronic ^{R} (block copolymer of ethylene oxide and propylene oxide with ethylenediamine) seem to improve the dissolution of this polymer in water but are not as effective as polyvinylalcohol. A composition of 1.2% poly(o-hydroxyaniline) and 1.2% polyvinylalcohol in water was spin coated on top of a multilayer resist system as described in Example 4. A thin coating of approximately 1000 angstrom of discharge layer was obtained with 2500 rpm. The conductivity of the discharge layer was about 0.1 S/cm. The wafer was hot-plate baked at 90°C for 1 min and the "Hontas Discharge Test" (Example 4) was carried out. The developed resist did not show any image distortion. The 2 micron square remained in the center of the 10 micron square. This indicates that there is no charging on the surface of the resist when a thin layer of conducting polymer is applied on top of it.

### Example 6

The same test as Example 4 and 5 was carried out both on control and with discharge layer on top of control using 50 KeV at 25°C. The test field was reduced to 1 x 1 micron squares in 5 x 5 micron boxes on 3.46 x 3.46 mm chips for the 50KeV tool. The resist without the discharge layer exhibited less image displacement with 50KeV than it had with 25 KeV, but the difference between the control and the sample with the discharge layer was still significant and indicated no charging on the surface of the resist.

### Example 7

Both the acid form and the ammonium salt form of poly 3-(2-ethane sulfonate) thiophene synthesized as described in Example 1 gave a conductivity of less than 10⁻³ S/cm measured by the 4-probe method. The polymer was therefore treated with ammonium persulfate as follows: to a suspension of 4.375% by weight of the above polymer in water was added 0.125% by weight of ammonium persulfate to give a final total solid content of 4.5%. The water solution was spin coated on top of the multilayer resist as described in Example 4. The spin speed was 2000 rpm and the resist thickness was 1200 angstrom. The post application bake was at 90°C for 1 min on hot plate. The oxidized polymer gave a conductivity between 10⁻² and 10⁻¹ S/cm. The E- beam exposure was done as described in Example 4. The final resist image did not show any image shift from center. In other words, no charging effect on the resist was found.

As a test for stability the thiophene polymer was retained in the presence of ferric trichloride in aqueous solution for a week, and was then converted to the ammonium salt form and a trace of sulfuric acid was added. The Hontas Discharge Test on a wafer prepared from the polymer once again showed no charging effect.

### Example 8

Poly(ethoxyaniline) is soluble in water- acetone mixture, but not in aqueous base. Multilayer resist systems prepared from poly(ethoxyaniline) were not conductive enough to pass the Hontas Discharge Test, and the layer was not removable with base developer.

### Example 9

The sulfonated polyaniline of Yue and Epstein (above) is only soluble in its nonconducting base form. An attempt to coat this polymer from ammonium hydroxide solution did not give a homogeneous coating.

### Example 10

The polystyrene sulfonate ammonium salt of Watanabe and Todokoro was coated on top of the multilayer resist system and tested as described in Example 4. The 2 micron square image exhibited a 2-4 micron displacement from the center of the 10 micron square. This indicates that the charging effect has been reduced but not removed, as would be expected from a polymer that conducts only by an ionic mechanism.

## Claims

1. A composition for dissipating the accumulated charge from a charged particle beam which comprises from 15 to 100% of an electrically conductive, aqueous base soluble polymer or oligomer chosen from the group consisting of substituted and unsubstituted polyparaphenylvinylenes, polyanilines, polyazines, polythiophenes, poly-p-phenylene sulfides, poly-p-phenylene oxides, polyfurans, polypyrroles, polyselenophenes, and polyacetylenes.

2. A composition according to claim 1 wherein said polymer or oligomer is a polyaniline or polythiophene.

3. A composition according to claim 2 wherein said polyaniline is poly (o-hydroxyaniline).

4. A composition according to claim 2 wherein said polythiophene is poly [3-(2-ethanesulfonate) thiophene].

5. An electrically conductive polymer or oligomer having the formula 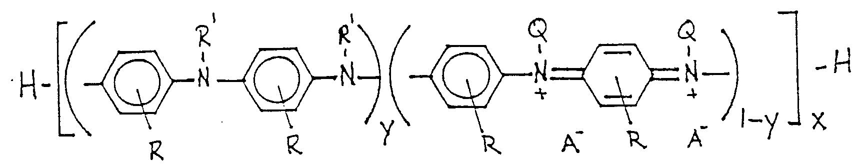 wherein:
R is OH, OCH₃ or COOH;
R¹ is hydrogen or lower-alkyl;
Q is hydrogen or lower-alkyl;
y is a number between zero and one
x is a number from 4 to 1,100; and
A⁻ is any anionic species.

6. A polymer according to claim 5 wherein Q is H and R is OH.

7. A polymer according to claim 6 wherein R¹ is hydrogen, y is from 0.4 tp 0.6, x is from 50 to 750 and A⁻ is Br⁻.

8. A process for preparing a polymer according to claim 6 which comprises reacting a polymer of formula 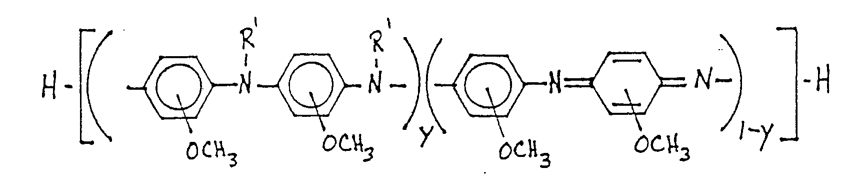 with 48% hydrobromic acid.

9. A process for preparing a polythiophene of formula 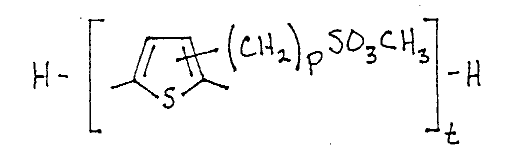 wherein t is an integer from 4 to 6,100 and p is an integer from 1 to 4 which comprises reacting a methyl
-(3-thienyl) alkylsulfonate with from about 2 to about 3 equivalents of ferric chloride in an inert solvent.

10. A process for improving the precision of a charged particle beam impinging on a dielectric surface which comprises applying over at least a part of said surface, a non-metallic, electrically conductive material chosen from the group consisting of aqueous base soluble substituted and unsubstituted polyparaphenylvinylenes, polyanilines, polyazines, polythiophenes, poly-p-phenylene sulfides, poly-p- phenylene oxides, polyfurans, polypyrroles, polyselenophenes, and polyacetylenes.

11. A process for electron beam lithography which comprises:
a) coating a substrate with at least one layer of a resist,
b) coating at least a portion of said resist layer with a nonmetallic, electrically conductive material chosen from the group consisting of aqueous base soluble substituted and unsubstituted polyparaphenylvinylenes, polyanilines, polyazines, polythiophenes, poly-p-phenylene sulfides, poly-p-phenylene oxides, polyfurans, polypyrroles, polyselenophenes, and polyacetylenes.
c) exposing said substrate with said resist and said nonmetallic, electrically conductive material thereon to an electron beam, said nonmetallic material substantially preventing charge accumulation; and
d) removing said nonmetallic material and developing said resist.

12. A process according to claim 11 wherein said resist is an aqueous base developable resist and said nonmetallic material is poly (o-hydroxyaniline).
